# EUROPEAN PATENT APPLICATION

(11) **EP 2 770 332 A1**
(43) Date of publication of application: **27.08.2014**
(21) Application number: 13155945.2
(22) Date of filing: 20.02.2013
(51) Int. Cl.: G01R 1/067

(54) **Contact probe**

(71) Applicant: Team Nanotec GmbH, 78052 Villingen-Schwenningen (DE)
(72) Inventor: Kalt, Samuel, 72760 Reutlingen (DE); Fritz, Georg, 72172 Sulz-Bergfelden (DE); Bayer, Thomas, 71083 Herrenberg (DE)
(74) Representative: DREISS Patentanwälte PartG mbB

(57) **Abstract**

The invention related to a contact probe for contacting a bump-like or plate like contact structure by pushing the probe towards the contact structure along a probing axis of the probe, the probe comprising a base section and at least two cantilever spring arms extending away from the base section, each cantilever spring arm comprising a cantilever contact section for contacting the contact structure to be probed.

## Description

The invention relates to a contact probe to be used for electrical functional testing of a contact structure in particular of a microelectronic device.

The electrical testing of microelectronic devices - on the wafer level or on the die (chip) level - has been an integral part of the IC manufacturing process since decades. This testing is required to sort out the defective dies either before mounting them on multi-chip modules or before shipping them as naked dies.

Known testing methods are based on the so called contact mode, i.e. contact probes or probe tips are brought into close mechanical contact with the contact structure to be probed (e.g. I/O pads of the electronic device). Electrical functional testing is then performed by sending and receiving electrical power and signals through the probe and/or the contact structure.

In order to obtain reliable contact testing results, the mechanical contact between probe tip and surface of the contact structure (I/O pad) has to guarantee for an electrically stable contact resistance. Since the metal surfaces of the pad surface and/or of the probe tip surface typically form a native oxide, a good electrical contact usually requires a "scrub" movement of the probe tip with respect to the contact structure (I/O pad). This way, the native oxide can be penetrated or locally removed and reliable contact resistance can be achieved.

This scrub movement of the probe improves in general the contact resistance. However, it deteriorates the bondability of the contact structure (I/O pad) of the tested device.

In the past, this disadvantage could be bypassed by having large diameter I/O pads or by using a different set of contact structures (e.g. separate I/O pads) for testing and for later bonding.

The design of the testing setup also has to take into account the layout of the contact structures to be tested. Commonly, the arrangement of the I/O pads has been in a linear way around the periphery of the die or in the center of memory dies.

For this kind of linear and mostly peripheral arrangements of I/O pads (typically for one or two rows of pads), tilted cantilever probes with pointed probe tips are usually being used. In such probes, the beam section of the cantilever probe extends tilted or even perpendicular to the tip section. These cantilever probes consist mostly of metal wires of millimeters up to centimeters in length, which are mechanically mounted in a so-called probe card. This probe card is usually optically adjusted against the device to be tested and then the probes are brought in contact with the device I/O pads as an entity. The cantilever like wire probes allow for an adjustable force, but a scrub movement of the probe tip is inherently connected to these kind of probes, leading to the problems mentioned above. Another disadvantage of these cantilever probes is a limited mechanical positional accuracy and a short life time before a necessary mechanical readjustment.

Another disadvantage of the tilted and/or linearly arranged cantilever probes is that they can only be arranged in a limited number of rows and not in full two-dimensional arrays (e.g. due to the necessary cantilever beam extending tilted or perpendicular to the probe tip). In the course of down-scaling of the devices, also the test devices have to be miniaturized. It is obvious that miniaturization of the tilted cantilever setup can be problematic.

A recently employed route to miniaturization of microelectronic devices is the so called "flip-chip" technology, where I/O pads spread basically equally over the active area of the chip. This design allows to realize three-dimensional stacked integrated circuits (3D-SICs). Compared with devices which are wire bonded from their periphery, the packing density can be increased.

In order to test densely packed arrays of contact structures (e.g. I/O pads), so called vertical probes can be employed. In these probes the force is directed perpendicular to the I/O pad surface. In known vertical probe assemblies, the probes are individually guided in electrically insulated "guide channels". Only the very probe tip reaches out of these channels and hence, these vertical probes have a much higher positional stability and a longer usability before a readjustment is required. The probe tip of these vertical probes is typically a blunt end of a metal wire. Due to the blunt end of the probe tips, a high contact force equivalent in the range of grams (for some tens of microns diameter) per probe is required to achieve a reliable contact resistance. The force is achieved by controlled bending of the individual probe wires, either by buckling beam or cantilever mode. These forces per probe lead to high forces for dies or wafers with large numbers of I/O pads, and at the same time the lateral scrub movement needs to be large and will result in poor bondability.

These current vertical probers show besides their disadvantages due to high vertical forces and large lateral scrub movements also limits in further lateral dimensional shrinking, because of their manufacturing methods using individual wire probes mounted one after the other into guide channels.

When down-sizing the dimensions of microelectronic devices, also the diameter and the pitch of I/O pads are undergoing a dimensional shrink. As a result, a considerable part of the pad is damaged due to the scrub of a contacting event, and the bondability is severely negatively impacted.

As recently investigated way to further miniaturization, 3D-SICs offer dense integration of possibly heterogeneous technologies at a small footprint containing small diameter and dense I/O pads. However, 3D-SICs have unique test challenges of their own. Typically, the three dimensional chip layout makes use of so called Through Silicon Vias (TSVs) in order to realize conductive connections from one side of the chip to the other. The probing of pre-bond dies with their numerous small and fragile TSV interconnects on wafer level is a challenge with respect to number, density of I/O pads as well as mechanical fragility of dies and TSVs. Unlike regular dies, the ones used for 3D-SICs are thinned compared to the original wafer thickness. Also the TSVs are thin and mechanical fragile which imposes limitations to the total mechanical load during testing.

The described chips (e.g. Post-bond stacks) show inherent non-planarity, due to different heights of stacks as well as the gaps ("streets") between stacked dies. Testing within these "streets" imposes mechanical constraints, which are not present in testing setups for a regular wafer or die. The use of tilted probes e.g. would be very limited. The mechanical force on such fragile, thinned dies and stacks of dies has to be minimized and at the same time, the electrical contacts have still to be stable.

The testing for 3D-SICs needs to be done on the same pads as the bonding, which makes a minimum scrub damage essential. The contact structures (also called: micro-bumps) of these 3D-devices are raised above the surrounding surface, and are hence even more prone to scrub damages when exerting lateral forces to the bumps.

With known probe technology, probably a minimum pitch of 35 µm (micrometers) between two contact structures could be handled. As discussed, however, the known probe designs usually lead to significant scrub marks in order to achieve a proper electrical contact. The known technology is therefore not sufficient to meet the requirements for testing 3D-SICs, which will eventually require pad and pitch dimensions well below 10 µm.

The present invention is aimed at overcoming the described shortcomings of state-of the art probe designs. In particular, the problem to be solved is to enable a reliable contact testing with minimized scrub damage of the contact structure to be tested, and to allow for testing of densely packed arrays of contact structures (especially contact pads or contact bumps).

This problem is solved by a contact probe with the features of claim 1. The contact probe is designed for contacting a bump-like or plate-like contact structure, in particular a micro bump as used e.g. for bonding of adjacent chips in 3D-SICs. In general, the contact structure can have any shape defined by its outer peripheral contour, e.g. a polygonal contour, an elliptic contour, an L-shaped contour or the like.

The contact probe exhibits a probing axis, wherein contacting of the contact structure is achieved by pushing the probe along the probing axis in mechanical contact with the contact structure. The probe comprises a base section and at least two cantilever spring arms extending away from the base section, and each cantilever spring arm comprises a cantilever contact section for contacting the contact structure to be probed. Each cantilever spring element is extending between the probe base section and the cantilever contact section.

Instead of a single probe tip, the probe according to the invention exhibits a structure which is split in different cantilever spring arms. This redundancy of contact sections leads to a better reliability of the mechanical contact between the probe and the contact structure and therefore enables a more reliable electrical testing.

The cantilever spring arms can be arranged in such a way, that the contact structure (e.g. bump or plate contact) is connected in certain advantageous positions, especially at the periphery or at the outer contour of the contact structure or contact bump. In particular, the cantilever spring arms are arranged such, that the cantilever contact section contacts the probe structure only at a peripheral area, e.g. around the circumference of a contact bump. As a result, scrub damage in a central area of the contact structure can be avoided and the later bonding of the contact structure is not impaired. The bondability is maintained.

The contact probe can for example comprise four or more cantilever spring arms arranged circumferentially so as to contact the perimeter of a contact structure to be tested. As a general aspect of the invention, any number of cantilever spring arms more than two, for example four, six, eight, or more can be used.

The cantilever spring arms can be arranged in positions at the base section, so that the cantilever contact sections are adapted to the outer contour of the contact structure to be probed. For example, the cantilever spring arms can be arranged along a curve corresponding to the contour line of the contact structure to be probed. The contact probes can therefore be manufactured according to individual needs by defining the positions at the base section, at which the cantilever spring arms are arranged.

The contacting forces between the cantilever contact section and the contact structure can be adjusted by the design of the cantilever spring arms. A more reliable contacting can be achieved by increasing the number of contact points and using different contact positions at a contact structure with different cantilever spring arms. The spring constant or stiffness of each of the cantilever spring arms with respect to a deflection in the lateral direction can be adapted to the shape of the contact structure to be probed and/or the geometrical arrangement of the different cantilever spring arms at the base section. This way, an optimal contacting can be achieved and lateral net forces exerted on the contact structure can be avoided. If, for example, the cantilever spring arms are arranged symmetrically around the probing axis, all spring constants can be equal. If, for example, the cantilever spring arms are arranged asymmetrically (e.g. adapted to the contour of an asymmetric contact structure), the spring constant of a selected cantilever spring arm (or arms) can be higher than the spring constant of other cantilever spring arms.

With the probe design according to the invention, a fully vertical probe design can be realized. The contacting force can be adjusted and limited by the design of the cantilever spring arms, because these arms extend away from the base section and can be laterally deflected when the probe is pushed in mechanical contact with the contact structure (along the probing axis).

Due to the vertical design, a plurality of probes can be arranged with parallel probing axis, which enables the testing of a dense array of even small contact pads or contact bumps. In conventional approaches such as a buckling beam probe (with a contact tip extending essentially perpendicular to the deflecting probe beam), the scalability is limited due to the space needed by the probe beam.

According to one aspect of the invention, each of the cantilever spring arms extends parallel to the probing axis. Therefore, the cantilever spring arms are preferably arranged in such a way, that they extend parallel to each other from the base section in their non-deflected state.

The cantilever spring arms are preferentially configured to elastically deflect in a lateral direction with respect to the probing axis when pushing the probe along the probing axis in contact with the contact structure to be probed. In this way, the at least two cantilever spring arms can bend laterally outwards and thereby engage the contact bump in a "gripping" or "embracing" fashion. This results in a more reliable electrical contact.

As a general aspect of the invention, each cantilever spring arm exhibits an axial dimension along its direction of extension between the base section and the cantilever contact section (i.e. preferably parallel to the probing axis) and a lateral dimension (e.g. essentially perpendicular to the axial direction), wherein the axial dimension is larger than the lateral dimension, for example three to ten times larger. In this sense, the cantilever spring arms can have beam-like, needle-like, rod-like or stick-like shape. This design allows for the described deflection in a lateral direction.

The spring constant or stiffness of the cantilever spring arm with respect to a deflection in the lateral direction can be adjusted by the shape of the cantilever spring arms. In particular, a defined variation of the cross-section of the cantilever spring arm along its extension from base section to cantilever contact section, or a proper choice of the axial dimension has a significant influence on the spring constant (or stiffness) of the cantilever spring arm. The mechanical properties can also be adjusted by the choice of the material for the cantilever spring arm or by a combination of different materials in a cantilever spring arm.

The different cantilever spring arms are preferably arranged in such a way, that the cantilever contact sections are disposed symmetrically with respect to the probing axis. When pushing the cantilever contact sections on contact with a contact bump, the mentioned design leads to the effect that no net lateral force is exerted on the contact bump.

According to another aspect of the invention, the cantilever spring arms are arranged so that all cantilever contact sections are laterally offset from the probing axis. In this sense, the cantilever contact sections do not intersect with the probing axis. When pushing such a probe towards a contact structure (e.g. bump), the cantilever spring arms are automatically deflected in a lateral direction away from the probing axis. Beyond that, the offset of the multiple cantilever contact sections from the probing axis lead to a self-centering force when pushing the probe in contact with the contact structure.

With the mentioned design, a contacting of the contact structure in its center region can be avoided. Instead, the contact between probe and contact section takes place mainly at the periphery of the contact structure.

To further improve this kind of lateral contacting of the contact structure, the cantilever spring arm can be arranged in such a way, that the cantilever contact sections are disposed along a circular line around the probing axis. In this case, contacting of the contact structure takes place only along a circular line at the periphery of the contact structure. As a result, no net lateral force is exerted to the contact structure, and pushing the probe in contact with the contact structure leads to a self-centering force on the probe.

The cantilever spring arms can be arranged such that the cantilever contact sections of the different cantilever spring arms define a probe contact area with an essentially circular cross section when viewed along the probing axis.

On the other hand, the cantilever spring arms can be arranged in such a way, that the cantilever contact sections are disposed along a polygonal line, e.g. a quadratic line, around the probing axis. In this case, the cantilever spring arms are preferentially arranged in a way that the cantilever contact sections define a probe contact area with an essentially polygonal, or quadratic cross section when viewed along the probing axis.

To further improve the contacting, the cantilever contact sections can comprise at least two contact surface sections converging in a ridge configured to contact the contact structure to be probed. By this ridge design, the scrub damage can be reduced as the contacting of the contact structure is achieved primarily by the ridge of the cantilever contact section. Due to the smaller contact area at the ridge, a higher contact pressure can be achieved.

The ridge is preferably extending away from the base section. However, the ridge can also be tilted, e.g. the ridge can extend away from the probing axis with an inclination away from the base section.

The two contact surface sections are preferably arranged in a roof-like shape, wherein the ridge of the roof is extending away from the base section. This design leads to a reduced contact area. Pushing the probe towards the contact structure therefore has only a small influence on the central area of the contact structure/contact bump.

According to a general aspect of the invention, the cantilever contact section of at least one cantilever spring arm comprises at least one edge structure, which extends beyond a surface of the cantilever contact section and which is configured to contact the contact structure to be probed. The edge structure preferably extends in a direction away from the base section, e.g. along the probing axis. When the probe is pushed towards and in contact with the contact structure, the edge can cut through a layer of native oxide which eventually forms at the surface of the contact structure. The edge structure exhibits a contact edge with a small edge radius. Even with a low total force exerted by the cantilever spring arm on the contact structure, a high contact pressure between the edge and the contact structure to be probed can be achieved. The edge structure preferably comprises a knife-like edge.

The edge structure preferably extends outward in a direction away from the probing axis with an inclination away from the base section. When pushing this kind of cantilever contact section towards a bump-like contact structure, the edge initially contacts the peripheral part of the contact bump and eventually cuts into the surface. Thereby, the central surface area of the contact bump is not corrupted, which improves the bondability after testing.

The cantilever contact section can also comprise two or more edge structures, which diverge along their extension outward away from the probing axis. When pushed towards a contact bump, such edges cut into the surface and can exert a squeezing force on contact sections between the diverging edges. This can lead to a more reliable electrical contacting.

As a general aspect of the invention, the base section comprises an electrical base contact area, wherein the cantilever contact sections of all the cantilever spring arms are in electrical contact with the base contact area. The base contact area can be used as a common contact for the probe for electrical testing of a contact structure. When the probe is pushed in contact with a contact structure, two or more cantilever spring arms serve as parallel conductors or as shunt circuit elements leading to a more reliable contacting.

Another possibility is that the base section comprises two or more separated contact areas, which are insulated with respect to each other and wherein each contact area is associated with a separate one of the cantilever spring arms. In this configuration, each cantilever spring arm forms an individual point probe. Using for example four cantilever spring arms leads to a four-point probe which allows in-situ self testing before testing the contact structure to be probed.

According to the invention, the probes (including base section and the cantilever spring arms) can be formed monolithically, e.g. using micro structuring technologies such as MEMS (micro-electro-mechanical system) technology or LIGA-technology (lithography, galvanic and forming). The underlying structuring methods such as lithography, plasma etching, wet etching, reactive ion etching, as well as deposition methods such as electro plating, chemical and physical vacuum deposition allow for down-scaling to the micrometer size.

The entire probe, or the base section and/or the cantilever spring arms can for example be made of highly doped silicon, metals or alloys such as non-oxidizing nickel alloys. This way, the cantilever contact section can be electrically connected to the base section or the base contact area.

The probe or the base section and/or the cantilever spring arms can also be fabricated from silicon (e.g. undoped silicon). In order to realize a conductive connection between the cantilever contact section and the base section (or base contact area), certain surfaces or sections of surfaces of the probe which extend between the cantilever contact section and the base section can be coated with a conductive material (such as metals). Possible coating materials are also: W, WC, Pt, Pd, PtIr, Rh, Au, SiC, PtSi, WSi2, MoSi2, TaSi2, PdSi2 or other carbides or silicides.

The mentioned coatings can also be provided in order to improve the resistance against mechanical wear.

Preferred embodiments and advantageous configurations of the invention are illustrated in the accompanying drawings, in which:
figure 1 is a perspective view of a connecting probe according to a first embodiment of the invention;
figure 2 illustrates the contact probe of figure 1, when pushed into contact with a contact structure to be probed;
figure 3 is a detailed view of the cantilever contact section of one cantilever spring arm according to figure 2;
figure 4 shows experimental data for measurements of the contact resistance of the contact probe when pushed into contact with an aluminium test contact structure;
figure 5 shows calculations for the stiffness of a cantilever spring arm for different geometry;
figure 6 is a perspective view of another embodiment of the contact probe according to the invention;
figure 7 is illustrating contact probe according to figure 6 when pushed into contact with a contact structure to be probed;
figures 8 and 9 illustrate an arrangement of a plurality of contact probes in order to form a probe array for testing arrays of contact structures;
figure 10 illustrates mounting and connecting of the plurality of probes according to figures 8 and 9;
figure 11 shows a schematic cross section of a probe card comprising an arrangement of a plurality of probes.

In the following description and in the figures, identical reference signs are used for corresponding features in the different figures.

A basic idea underlying embodiments of the contact probes according to the invention is to split one single probe into at least two or more probe arms, to arrange these probe arms circumferentially at the perimeter of a contact structure to be probed and to shape each probe arm at its contact interface with a knife-like edge.

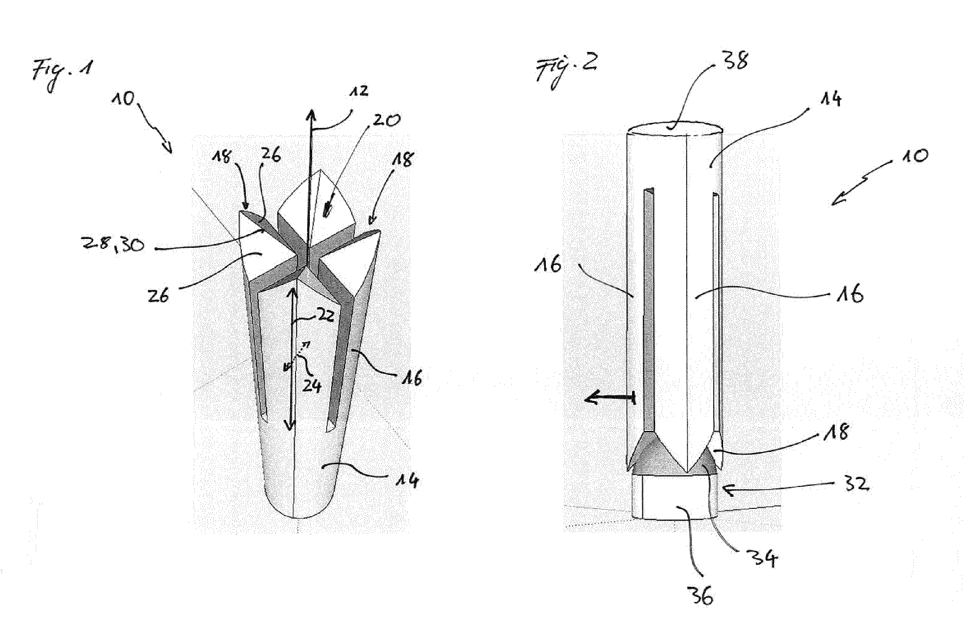

Figure 1 shows a contact probe 10, for which a probing axis 12 is defined. For probing a contact structure the contact probe 10 can be pushed along the probing axis 12 towards the contact structure and in mechanical contact with the contact structure.

The contact probe 10 comprises a base section 14 and four cantilever spring arms 16. The cantilever spring arms 16 extend away from the base section 14 parallel to the direction of the probing axis 12.

Each cantilever spring arm comprises a cantilever contact section 18 at its end part oriented away from the base section 14. The cantilever contact sections 18 of the four cantilever spring arms define a probe contact area 20 of the contact probe 10. In order to test a contact structure, the probe contact area 20 of the contact probe 10 is pushed along the probing axis 12 in mechanical contact with the contact structure.

As indicated for one of the cantilever spring arms 16, each cantilever spring arm 16 has an axial dimension 22 along its axial direction of extension between the base section 14 and the cantilever contact section 18 (i.e. parallel to the probing axis 12). As also illustrated in figure 1 for the cantilever spring arm 16, a lateral dimension 24 perpendicular to the axial dimension 22 can be defined (in the example shown, the lateral dimension 24 is measured perpendicular to the axial dimension 22 in a radial direction away from the probing axis 12). According to a general aspect of the invention, the axial dimension 22 is larger than the lateral dimension, for example three to five times larger (or other ratios depending on the desired properties).

The cantilever spring arms 16 are configured such that the probing axis 12 does not intersect with the cantilever contact sections 18 of the different cantilever spring arms 16. In this sense, the cantilever spring arms 16 are laterally offset from the probing axis 12. The cantilever spring arms 16 are arranged at the base section 14 in such a way, that the different cantilever contact section 18 are disposed along a circular line around the probing axis 12 and in a plane perpendicular to the probing axis 12. Therefore, the probe contact area 20 defined by the cantilever contact sections exhibits an essentially circular cross-section when viewed along the probing axis 12.

In the example shown in figure 1, each cantilever contact section 18 comprises two contact surface sections 26. Each of the contact surface section 26 is tilted in such a way, that it extends outward away from the probing axis 12 and away from the base section 14.

The two contact surface sections 26 are furthermore tilted with respect to each other in such a way, that they form a roof-like structure with a ridge 28 extending away from the probing axis 12 with an inclination away from the base section 14. Therefore, the two contact surface sections 26 converge in the ridge 28. The ridge 28 can be viewed as an edge structure 30, which extends beyond a surface of the cantilever contact section 18. Therefore, when the probe contact area 20 is pushed into contact with a contact structure to be probed, the ridge 28 is the first part of the cantilever contact section 18 that is brought into mechanical contact with the contact structure. Due to the roof-like design of the contact surface section 26, the edge structure 30 extends outward in a direction away from the probing axis 12 and with an inclination away from the base section 14 along the radial extension of the edge structure 30.

In figure 2, the contact probe 10 is shown in a state pushed towards a contact structure 32 in a direction along the probing axis 12 in such a way, that the cantilever contact sections 18 of the cantilever spring arms 16 are brought into mechanical contact with the contact structure 32. In the shown example, the contact structure 32 is configured as a so-called contact bump having a hemisphere-shaped top 34 and a cylindrical pole 36. This kind of contact structure 32 can be used to interconnect different layers of three dimensional stacked ICs (3D-SICs) as described before. To establish contact between different stacked chips, a contact bump on the surface of one chip are brought into contact with a corresponding contact bump or similar structure on a surface of a chip subsequent in the layer structure of the 3D-SIC.

Because of the elongate structure of each cantilever spring arm 16 extending along the probing axis 12 (as described in the context of figure 1), each cantilever spring arm 16 is configured as to elastically deflect in a direction lateral with respect to the probing axis 12 when the cantilever contact sections 18 are pushed into contact with the contact structure 32.

Because of the inclination of the edge structure 30 away from the probing axis 12 and away from the base section 14, each cantilever spring arm 16 is bent radially outward from the probing axis 12, when the probe 10 is pushed towards and in mechanical contact with the contact structure 32. In figure 2, this deflection is indicated by an arrow for one of the cantilever spring arms 16.

According to figures 1 and 2, the cantilever spring arms 16 are preferably arranged in such a way, that the contact sections 18 are disposed symmetrically with respect to the probing axis 12. In the example shown in figure 1 and 2, the edge structures 30, which are brought into contact with the contact structure 32 first, when the probe 10 is pushed against the contact structure 32, extend radically outward from the probing axis 12. Because of this symmetric arrangement, no net lateral force is exerted on the contact bump 32, when the contact probe 10 is pushed towards the contact structure 32 and the cantilever spring arms 16 are deflected outward as described before.

The base section 14 of the contact probe 10 comprises an electrical base contact area 38, which is electrically connected with the cantilever contact sections 18 of the different cantilever spring arms 16. In order to establish this electrical connection between the cantilever contact sections 18 and the base contact area 38, the contact probe 10 can comprise at least one surface section which is coated with a conductive coating material. This coated surface section can for example be a surface of a cantilever spring arm 16 facing towards another cantilever spring arm 16 or towards the probing axis 12 (e.g. an inner surface). The conductive coating preferably extends between the cantilever conduct section 18 and the base section 14, and can e.g. also cover the cantilever contact section 18.

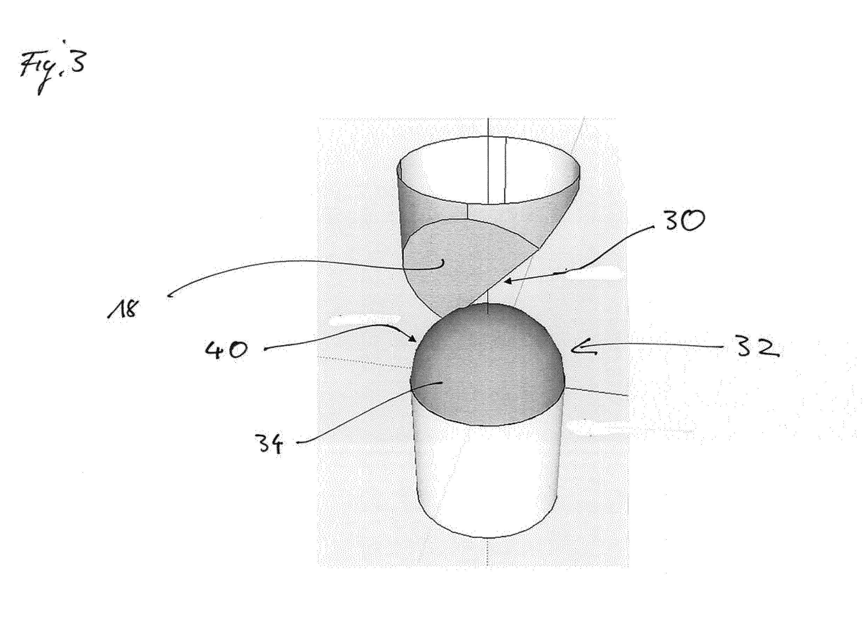

As visualized in the detailed view according to figure 3, the cantilever spring arms 16 and the cantilever contact section 18 are preferably arranged in such a way, that the edge structure 30 of the cantilever contact section 18 is brought into mechanical contact with the contact structure 32 (contact bump) only at a periphery 40, for example at the circumference of the hemisphere-shaped top 34 of a contact bump 32 (see figure 3). Because of the small edge radius of the edge structure 30, a high contact pressure can be achieved even for a relatively low total contact force transmitted by the cantilever spring arm 16 to the contact structure 34. In particular, the contact pressure can be high enough for the edge structure 30 to cut through a layer of native surface oxide, which can form on the top 34 of the contact structure 32.

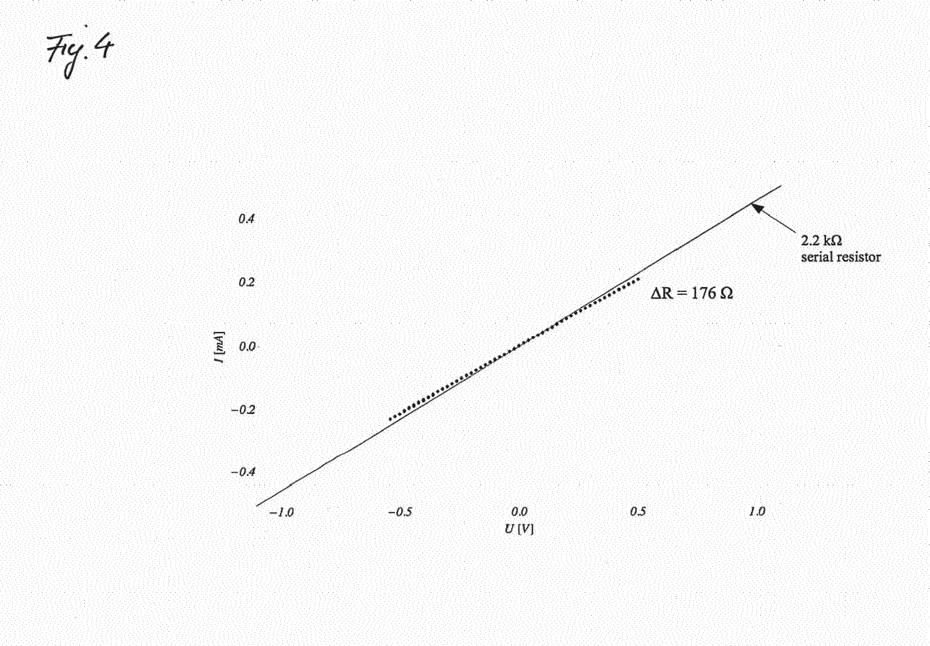

Figure 4 shows experimental data for the current measured through a base contact area 38 of a contact probe 10 as a function of the voltage applied between the contact probe 10 and a contact structure 32 to be probed. For the measurement, a single cantilever spring arm with its contact section 18 was brought into mechanical contact with the contact structure. In this experiment, the contact probe 10 comprises a conductive coating (tungsten carbide on top of silicon probe). The contact structure is provided by a sputtered film of aluminium, which exhibits a layer of native surface oxides. For the measurement, a serial resistor of 2,2 kΩ in series with the base contact area 38 is used (solid line in figure 4). The measured current values as a function of the applied voltage are illustrated by dots in Figure 4. From the deviation of the doted line with respect to the solid line, a contact resistance of 176 Ω for a single cantilever spring arm can be derived.

The geometrical properties of the cantilever spring arm 16 have significant influence on its stiffness or spring constant with respect to a deflection perpendicular to the probing axis 12. Beyond that, the choice of material for the cantilever spring arm 16 determines the stiffness or spring constant.

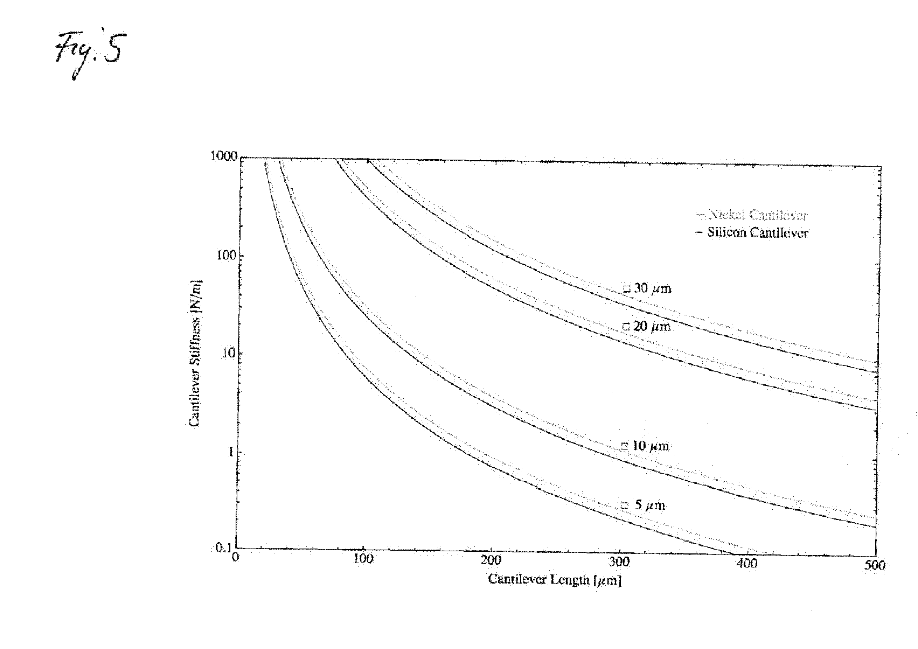

Figure 5 shows calculations for the cantilever spring constant (stiffness) for cantilever spring arms formed from different materials (nickel and silicon). Different curves are shown for cantilever spring arm diameters of five, ten, twenty, thirty micrometers as a function of cantilever length. The stiffness with respect to a lateral deflection of the cantilever spring arm decreases with decreasing diameter (lateral dimension 24) and increasing cantilever lengths (axial dimension 22). As apparent from figure 5, by varying the axial dimension 22 of a cantilever spring arm 16 between around fifty and around five hundred micrometers and a proper choice of lateral dimension 24 and/or material, a stiffness in the range of one to one thousand Newton per meter can be realized, which is sufficient to provide reliable contacting and allows to adapt the probe design to various different purposes.

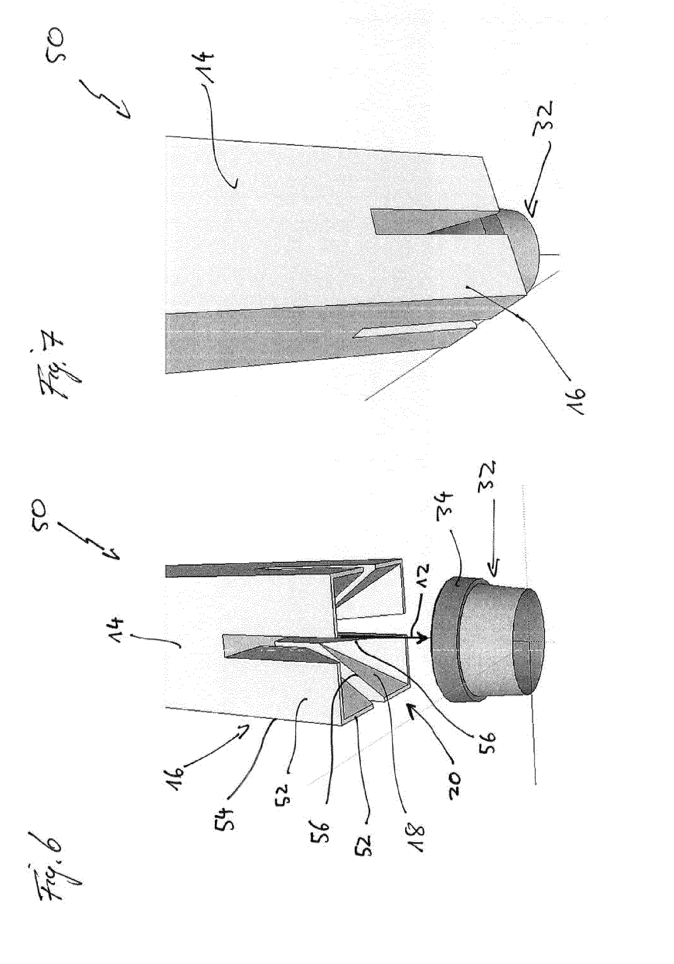

In figure 6 and 7, a contact probe 50 with a different geometry is illustrated. Each cantilever spring arm 16 of the contact probe 50 comprises two cantilever wall segments 52, which extend parallel to the probing axis 12 from the base section 40 towards a probe contact area 20 of the contact probe 50. The two cantilever wall segment 52 extend perpendicular to each other and converge in a outer cantilever edge 54 extending parallel to the probing axis 12 (and which in the shown example limits the cantilever spring arm 16 in its extension away from the probing axis 12).

The cantilever wall segments 52 are arranged such, that the probe contact area 20 of the contact probe 50 exhibits an essentially quadratic cross section when viewed along the probing axis 12.

Those surface segments of the cantilever wall segment 52, which are facing the probing axis 12, define the cantilever contact section 18 of the cantilever spring arm 16 in figure 6 and 7. The cantilever wall segments 52 of the different cantilever spring arm 16 are arranged such, that the cantilever contact sections 18 are disposed essentially along a quadratic line around the probing axis 12 when viewed along the probing axis 12.

In the shown example, each cantilever contact section 18 comprises two edge structures 56, which diverge along their direction of extension outward away from the probing axis 12.

In figure 7, the contact probe 50 is pushed towards a contact structure 32, which in this case comprises a disk shaped top 34 (micro pad). The two edge structure 56 of each cantilever spring arm 16 contact the top 34 of the contact structure 32 only at its circumference, thereby leaving the centre area of the top 34 unaffected by a probing process.

For the contact probe 50, the preferred arrangements as described for the contact probe 10 can also be employed, for example a conductive coating for surfaces of the cantilever spring arm 16 and/or the whole contact probe 50.

Due to the perpendicular extension of the cantilever wall segment 52, the cantilever spring arms 16 of the contact probe 50 in general exhibit a significantly higher stiffness against lateral deflection away from the probing axis 12 than the cantilever spring arms shown in figures 1 and 2.

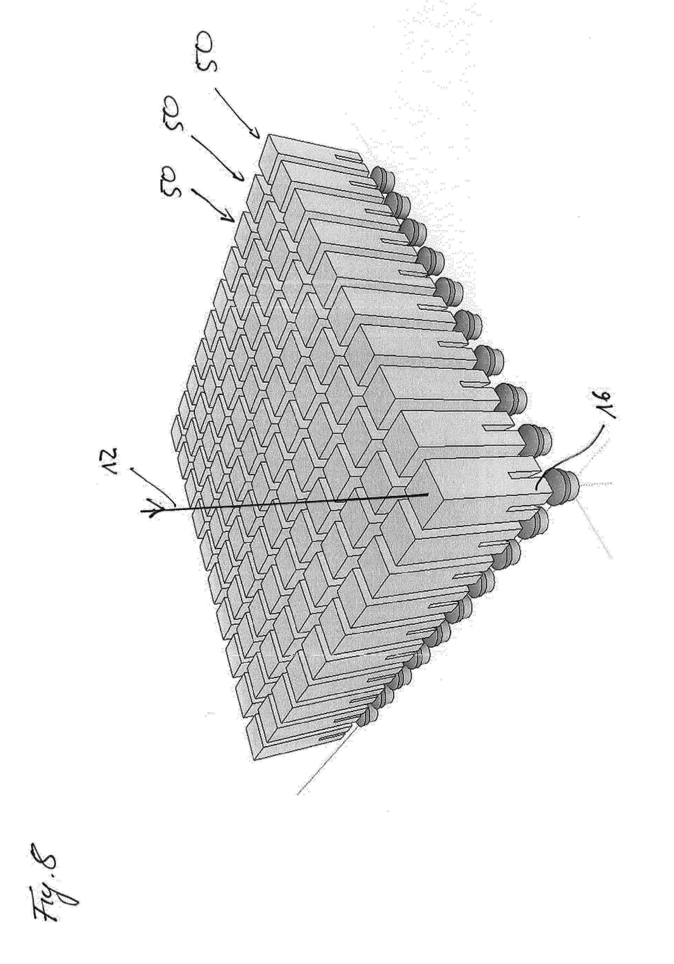

In figure 8, an arrangement of a plurality of contact probes 50 is shown. As a matter of course, also contact probes 10 as described in figures 1 to 3 or any other embodiment of the contact probe according to the invention can be used. In the shown example, the contact probes 50 are arranged in a quadratic array (e.g. 10 times 10 probes), wherein the probing axes 12 of all contact probes 50 are oriented parallel to each other.

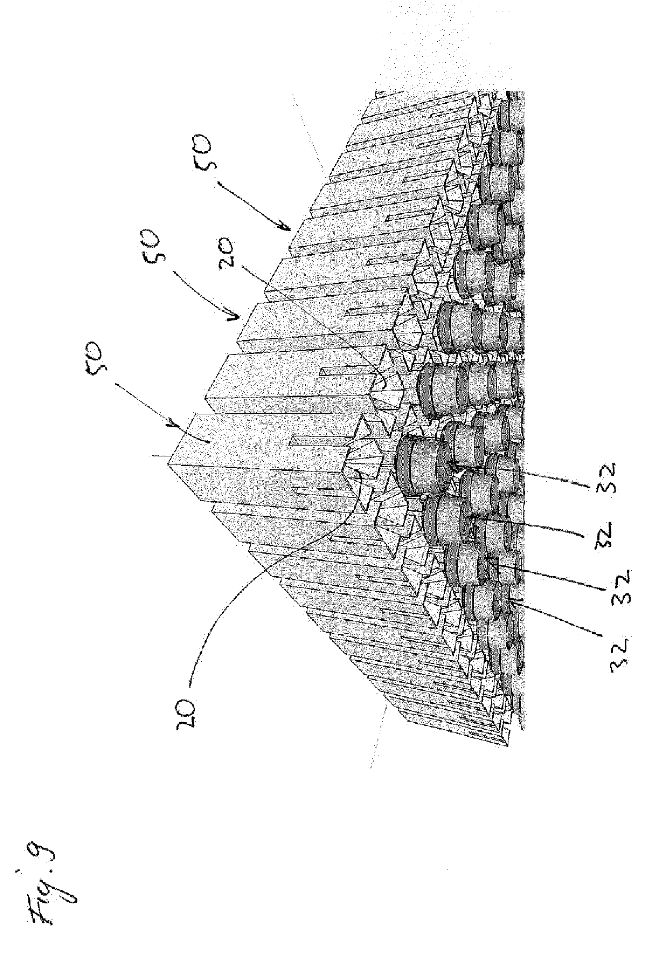

As shown in figure 9, this arrangement allows for electrical testing of arrays of contact structures 32 (which are in the shown example configured with disc-shaped tops similar to figures 6 and 7; however, other geometries for contact structures can be employed). The different contact probes 50 are arranged such, that the probe contact areas 20 of the different contact probes 50 are disposed with the same pitch size as the contact structures 32.

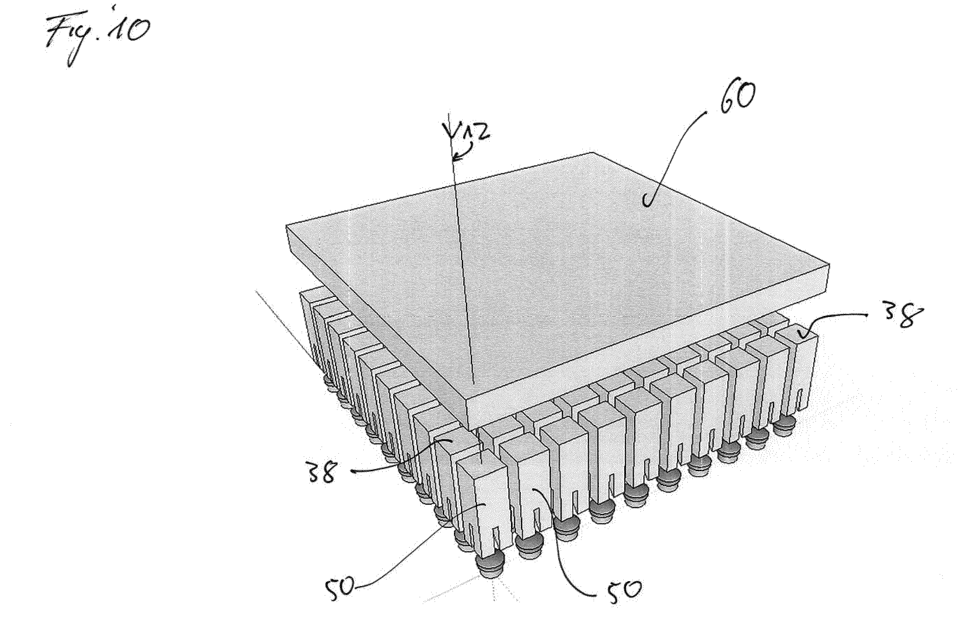

Figure 10 illustrates, how the arrangement of contact probes 50 shown in figures 8 and 9 can be mounted and how the individual contact probes 50 can be individually contacted in order to allow individual electrical testing of each of the contact structures 32 (see figures 8 and 9). The probes 50 are mounted in an array fashion on a plate-like redistribution wafer 60. The probing axes 12 of the different contact probes 50 preferably extend perpendicular away from the plane defined by the redistribution wafer 60.

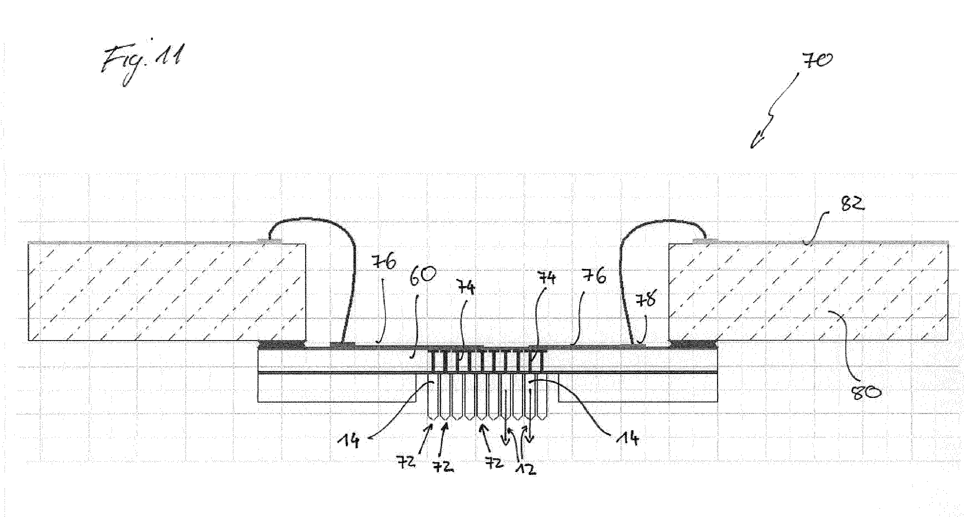

The individual contact probes 50 are electrically contacted via their base contact area 38, which is described in more detail for the embodiment described in figure 11.

The contact probes according to the invention are preferably used in so-called probe cards for contact testing of arrays of contact structure. As a general aspect, such probe cards comprise a plurality of probes according to the invention, which are arranged in such a way, that their probing axis extend in parallel to each other.

In figure 11, a probe card 70 is shown in a cross section extending parallel to the direction of the probing axis 12 of a plurality of contact probes 72 according to the invention (e.g. contact probes 10 and/or 50).

Each contact probe 72 is attached with its base section 14 at a redistribution wafer 60. The redistribution wafer 60 has a plate-like shape and extends perpendicular to the direction of the probing axis 12. The redistribution wafer 60 comprises a plurality of through contacts 74 extending from one surface of the redistribution wafer 60 to the opposite surface. Each through contact 74 is associated with one contact probe 72. The respective contact probe 72 is electrically connected with its associated through contact 74 via the base contact area 38 of the contact probe 72 (e.g. figure 10).

The redistribution wafer 60 can be configured as a silicon wafer comprising a plurality of through silicon vias (TSV) extending from one wafer surface to the opposite wafer surface. The TSVs can form the through contacts 74.

According to a general aspect of the invention, the redistribution wafer 60 and the plurality of contact probes 72 can be fabricated monolithically in such a way, that each contact probe 72 is electrically connected to one through contact 74. However, a modular design is also possible where each probe 72 is mounted to the redistribution wafer 60 so that electrical contact is established.

On its surface opposite to the contact probes 72, the redistribution wafer 60 may comprise an electrical redistribution circuitry 76 (e.g. serving as first level fan-out) leading to individual contact pads 78 for each contact probe 72.

The assembly of redistribution wafer 60 and contact probe 72 can be mounted on a frame 80 in such a way, that the contact probes 72 can be pushed into contact with contact structures to be probed along the probing axis 12. The frame 80 can comprise a printed circuit board 82 in order to electrically connect the contact probes 72 to a measurement equipment (e.g. serving as second level fan-out). As indicated in figure 11, the electrical connection between the electrical redistribution circuitry 76 and the printed circuit board 82 may be established via wire bonding between the contact pads 78 of the redistribution wafer 60 and corresponding contact pads of the printed circuit board 82.

## Claims

1. Contact probe (10, 50) for contacting a contact structure (32) by pushing the probe (10, 50) towards the contact structure (32) along a probing axis (12) of the probe,
the probe (10, 50) comprising a base section (14) and at least two cantilever spring arms (16) extending away from the base section (14),
each cantilever spring arm (16) comprising a cantilever contact section (18) for contacting the contact structure (32) to be probed.

2. Contact probe (10, 50) according to claim 1, **characterized in that** each cantilever spring arm (16) extends parallel to the probing axis (12).

3. Contact probe (10, 50) according to one of the preceding claims, **characterized in that** the cantilever spring arms (16) are configured to elastically deflect in a lateral direction with respect to the probing axis (12).

4. Contact probe (10, 50) according to one of the preceding claims, **characterized in that** each cantilever spring arm (16) has an axial dimension (22) along its axial direction of extension between the base section (14) and the cantilever contact section (18) and a lateral dimension (24), wherein the axial dimension (22) is larger than the lateral dimension.

5. Contact probe (10, 50) according to one of the preceding claims, **characterized in that** the cantilever spring arms (16) are arranged in such a way that the contact sections (18) are disposed symmetrically with respect to the probing axis (12).

6. Contact probe (10, 50) according to one of the preceding claims, **characterized in that** the cantilever spring arms (16) are arranged in such a way that all cantilever contact sections (18) are laterally offset from the probing axis (12).

7. Contact probe (10) according to one of the preceding claims, **characterized in that** the cantilever spring arms (16) are arranged in such a way that the cantilever contact sections (18) are disposed along a circular line around the probing axis (12).

8. Contact probe (10) according to one of the preceding claims, **characterized in that** the cantilever spring arms (16) are configures such that the cantilever contact sections (18) define a probe contact area (20) with essentially circular cross section when viewed along the probing axis (12).

9. Contact probe (50) according to one of the claims 1 to 6, **characterized in that** the cantilever spring arms (16) are arranged in such a way that the cantilever contact sections (18) are disposed along a polygonal line, especially quadratic line, around the probing axis (12).

10. Contact probe (50) according to one of the claims 1 to 6 or 9, **characterized in that** the cantilever spring arms (16) are configured such that the cantilever contact sections (18) define a probe contact area (20) with essentially polygonal, especially quadratic, cross section when viewed along the probing axis (12).

11. Contact probe (10) according to one of the preceding claims, **characterized in that** the cantilever contact section (18) comprises at least two contact surface sections (26) converging in a ridge (28) configured to contact the contact structure (32) to be probed.

12. Contact probe (10, 50) according to one of the preceding claims, **characterized in that** the cantilever contact section (18) comprises at least one edge structure (28, 30) extending beyond a surface of the cantilever contact section (18) configured to contact the contact structure (32) to be probed.

13. Contact probe (10) according to claim 12, **characterized in that** the edge structure (30) extends in a direction away from the probing axis (12) with an inclination away from the base section (14).

14. Contact probe (10, 50) according to one of the preceding claims, **characterized in that** the base section (14) comprises an electrical base contact area (38) and the cantilever contact sections (18) of all cantilever spring arms are in electrical contact with the base contact area (38).

15. Contact probe according to one of the preceding claims, **characterized in that** at least one surface section of the cantilever spring arms and/or the base section is coated with a conductive coating material.
